Europäisches Patentamt

**European Patent Office**

**Office européen des brevets**

(11) Veröffentlichungsnummer: **0 147 640**
**A1**

(12) # EUROPÄISCHE PATENTANMELDUNG

(21) Anmeldenummer: **84114274.8**

(22) Anmeldetag: **26.11.84**

(51) Int. Cl.⁴: **H 01 L 21/60**
**//H01L23/48**

(30) Priorität: **30.11.83 DE 3343362**

(43) Veröffentlichungstag der Anmeldung:
**10.07.85 Patentblatt 85/28**

(84) Benannte Vertragsstaaten:
**AT DE FR GB IT**

(71) Anmelder: **Siemens Aktiengesellschaft**
**Berlin und München Wittelsbacherplatz 2**
**D-8000 München 2(DE)**

(72) Erfinder: **Pammer, Erich, Dr. rer. nat.**
**Platanenstrasse 59**
**D-8028 Taufkirchen(DE)**

(72) Erfinder: **Bischofberger, Otfried**
**Helene-Mayer-Ring 10**
**D-8000 München 40(DE)**

(54) **Verfahren zur galvanischen Herstellung metallischer, höckerartiger Anschlusskontakte.**

(57) Die Erfindung betrifft ein Verfahren zur galvanischen Herstellung höckerartiger Anschlußkontakte von Halbleiterbauelementen, wobei die Anschlußkontakte aus ätzbaren Metallen bestehen, mit einem Oberflächenüberzug aus Gold, wobei dieser in einem ersten und in einem zweiten Arbeitsschritt jeweils chemisch auf den Anschlußkontakten abgeschieden wird. Im ersten Arbeitsschritt erfolgt die Abscheidung in einer Dicke von 10 bis 200 nm, im zweiten Arbeitsschritt in einer Dicke von 50 bis 200 nm. Zwischen den beiden Arbeitsschritten finden Ätzvorgänge und eine Temperung statt. Bei den Ätzvorgängen wird die im ersten Arbeitsschritt aufgebrachte Oberflächenschicht als Ätzmaske für die Anschlußkontakte benützt. Bei der Temperung diffundiert diese Oberflächenschicht dann in die Anschlußkontakte hinein. Dadurch bleibt die Lötfähigkeit der Anschlußkontakte über einen längeren Zeitraum hinweg, als sonst üblich, erhalten (Faktor 20).

EP 0 147 640 A1

Siemens Aktiengesellschaft
Berlin und München

**0147640**

Unser Zeichen

VPA **83** P **1914** E

Verfahren zur galvanischen Herstellung metallischer
höckerartiger Anschlußkontakte

Die Erfindung betrifft ein Verfahren zur galvanischen
Herstellung metallischer, höckerartiger Anschlußkontakte
von Halbleiterbauelementen nach dem Oberbegriff des
Patentanspruches 1.

In der modernen Halbleiterindustrie, speziell bei der
Fertigung integrierter Halbleiterbauelemente, wird die
automatische Bandmontage ("Tape Automatic Bonding", TAB)
in steigendem Maße eingesetzt. Eine der Grundvoraussetzungen bei der Halbleiterfertigung nach dieser TAB-
Technologie besteht darin, daß das zu montierende Halbleiterbauelement (Chip) an den zur Kontaktierung vorgesehenen Stellen (Pads) nicht, wir früher üblich,
metallisierte Kontaktflächen, beispielsweise bestehend
aus Aluminium, besitzt, sondern höckerartige, metallische
Anschlußkontakte (z.B. aus Kupfer), die die Chipoberfläche überragen.

Bei längerer Lagerung oxidieren kupferne Anschlußkontakte
bekanntermaßen an ihrer Oberfläche, was die bei Kupfer
an sich gute Lötfähigkeit vermindert. Um dies zu verhindern, werden solche Anschlußkontakte im allgemeinen
mit einer ausreichend dicken Goldschicht überzogen. Diese
Goldschicht diffundiert jedoch, auch bereits bei Zimmertemperatur, zu einem gewissen Teil in die Oberfläche der
Anschlußkontakte hinein, was bei der Ermittlung der erforderlichen Dicke des Goldüberzuges zu berücksichtigen
ist.

Ke 1 Gae / 29.11.1983

0147640

Zwischen den Anschlußkontakten und den zugehörigen, chipinternen Leitbahnen befindet sich eine dünne, metallische Schichtfolge, die als Haftschicht und Diffusionssperre wirkt. Beispielsweise besteht diese aus Titan und Kupfer oder Titan-Wolfram und Kupfer. Bekannte Herstellungsverfahren für die dünne, metallische Schichtfolge und die Anschlußkontakte bestehen darin, die einzelnen verwendeten Materialien ganzflächig auf das Halbleiterbauelement aufzudampfen bzw. aufzusputtern und diese vermittels üblicher photolithographischer Verfahren an den Stellen mit Photolack zu maskieren, an denen die Anschlußkontakte entstehen sollen. In den restlichen, nicht maskierten Bereichen des Chips werden die zuvor aufgedampften Materialien durch naßchemische Verfahren wieder abgeätzt. Bei dem ganzflächigen Bedampfen des Halbleiterschaltkreises mit dem Material für die Anschlußkontakte, beispielsweise Kupfer in der Stärke von 20 $\mu$m, besteht infolge zu hoher Bedampfungswärme und der unterschiedlichen Temperaturausdehnungskoeffizienten des Halbleitergrundmaterials, im allgemeinen Silicium, und des Anschlußkontaktmaterials (Kupfer) die Gefahr, daß erhebliche Durchbiegungen der zu bearbeitenden Halbleiterscheiben, Verspannungen, Kristallbrüche und -risse innerhalb des Halbleiterbauelementes entstehen sowie daß eine Schädigung (Risse) bei der als Schutz der Halbleiteroberfläche vor mechanischer Beschädigung auf diese aufgebrachten sog. Endpassivierungsschicht eintritt. Beispielsweise wurden folgende Durchbiegungen an ca. 400 $\mu$m dicken Siliciumscheiben bei einem Kupferauftrag von jeweils 20 $\mu$m gemessen:

bei 3-Zoll-Scheiben: 180 $\mu$m ± 20 $\mu$m;

bei 4-Zoll-Scheiben: 300 $\mu$m ± 40 $\mu$m.

Außer den beschriebenen mechanischen Schäden treten aufgrund der Durchbiegungen noch Fehljustierungen bei der nachfolgenden Phototechnikmaskierung auf.

Scheidet man Anschlußkontakte aus Kupfer anstelle von ganzflächiger Bedampfung, Phototechnikschritten und Ätzung des überschüssigen Kupfermaterials hingegen galvanisch ab, so treten die vorgenannten Schädigungen mit Sicherheit nicht auf. Es entsteht jedoch ein neues Problem:
Die zunächst ganzflächig aufgebrachte dünne metallische Schichtfolge muß nach der galvanischen Abscheidung der Anschlußkontakte in den Bereichen außerhalb dieser wieder abgeätzt werden. Bei diesem Ätzvorgang werden jedoch die Anschlußkontakte mit angegriffen, wodurch erhebliche Verätzungen an diesen auftreten, die infolge unterschiedlichen Ätzabtrages zu erheblichen Ausfällen bei einem später stattfindenden Lötbonden führen.

Aufgabe der vorliegenden Erfindung ist es, ein möglichst einfaches Verfahren zu schaffen, das die galvanische Herstellung höckerartiger Anschlußkontakte aus ätzbaren Metallen ermöglicht, ohne beim Ätzen der dünnen, metallischen Schichtfolge die Anschlußkontakte mit zu verätzen.

Erfindungsgemäß wird diese Aufgabe bei einem Verfahren der eingangs genannten Art durch die Merkmale des kennzeichnenden Teiles des Patentanspruches 1 gelöst.

Die Erfindung ist in vorteilhafter Weise anwendbar auf alle bekannten Halbleiterschaltkreise, unabhängig von der verwendeten Schaltkreistechnologie wie z.B. auf bipolare und MOS-Schaltkreise.

Vorteilhafte Ausführungen des erfindungsgemäßen Herstellungsverfahrens sind in Unteransprüchen gekennzeichnet.

Die Erfindung wird im folgenden anhand eines Ausführungsbeispieles erläutert:

Auf nach bekannten Verfahren galvanisch hergestellte höckerartige Anschlußkontakte eines Halbleiterschaltkreises wird erfindungsgemäß in einem ersten Arbeitsschritt ein Oberflächenüberzug aus Gold stromlos in einer Dicke von 10 bis 200 nm chemisch abgeschieden. Die Abscheidung kann nach üblichem Stand der Technik, beispielsweise unter Verwendung von Kalium-Gold-Zyanid-Komplexen mit einem pH-Wert von 5 bis 9, erfolgen. Anschließend werden in ebenfalls bekannter Weise die einzelnen Schichten der dünnen, metallischen Schichtfolge in den Bereichen außerhalb der Anschlußkontakte wieder abgeätzt, wobei in vorteilhafter Weise der zuvor auf die Anschlußkontakte aufgebrachte Oberflächenüberzug aus Gold diese vor dem Angriff durch die verwendeten Ätzmittel schützt. Der Oberflächenüberzug aus Gold besitzt also die vorteilhafte Schutzwirkung einer Ätzmaske. Um gutes elektrisches Verhalten der Schaltungen innerhalb der Halbleiterbauelemente (z.B. Linearität von Stromverstärkungskurven),das insbesondere durch das Aufdampfen bzw. Aufsputtern der dünnen, metallischen Schichtfolge erheblich verschlechtert worden ist, wieder zu erreichen, erwies sich erfindungsgemäß als unbedingt notwendig, anschließend eine Temperung der Halbleiterbauelemente in Stickstoff-, Formiergas- oder Wasserstoffatmosphäre für 5 bis 30 Minuten bei 200 bis 450° C durchzuführen. Dabei diffundiert jedoch der im ersten Arbeitsschritt auf die Anschluß-

0147640

kontakte aufgebrachte Oberflächenüberzug aus Gold vollständig in diese ein.

Da hierdurch die Anschlußkontakte vor Oxidation und Korrosion durch atmosphärische Einflüsse etc. nicht mehr geschützt sind, wird erfindungsgemäß in einem zweiten Arbeitsschritt jetzt ein weiterer Oberflächenüberzug aus Gold auf die Anschlußkontakte aufgebracht. Dies kann auf dieselbe Art und Weise wir im ersten Arbeitsschritt erfolgen. In vorteilhafter Weise beträgt hierbei die Dicke dieses Oberflächenüberzuges nur 50 bis 200 nm, um eine gute Lötfähigkeit der Anschlußkontakte auch über lange Lagerzeiten hinweg zu gewährleisten. Dieser Effekt wird bei der erfindungsgemäßen geringen Dicke des Oberflächenüberzuges des zweiten Arbeitsschrittes durch die vorteilhafte, oben beschriebene Durchführung der Temperung erreicht, bei der eine Anreicherung des Goldes des im ersten Arbeitsschritt aufgebrachten Oberflächenüberzuges an der Oberfläche der Anschlußkontakte erhalten bleibt. Somit wird die Eindiffusion des Goldes des Oberflächenüberzuges des zweiten Arbeitsganges in die Anschlußkontakte verhindert.

Versuche ergaben, daß der Erhalt der guten Lötfähigkeit von Anschlußkontakten, die nach dem erfindungsgemäßen Verfahren hergestellt wurden, gegenüber solchen Anschlußkontakten, in die vor einem Aufbringen eines Oberflächenüberzuges aus Gold kein Gold eindiffundiert war, um den Faktor 20 verlängert werden konnte.

Patentansprüche

1. Verfahren zur galvanischen Herstellung höckerartiger Anschlußkontakte von Halbleiterbauelementen, wobei die Anschlußkontakte aus ätzbaren Metallen mit einem Oberflächenüberzug aus Gold bestehen, unter denen eine dünne metallische Schichtfolge als Haftschicht und Diffusionssperre liegt, d a d u r c h   g e k e n n z e i c h - n e t,   daß das Aufbringen des Oberflächenüberzuges aus Gold in einem ersten und in einem zweiten Arbeitsschritt erfolgt, daß der im ersten Arbeitsschritt aufgebrachte Oberflächenüberzug als Ätzschutz entsprechend einer Ätzmaske für ein Ätzen der dünnen metallischen Schichtfolge zwischen dem ersten und dem zweiten Arbeitsschritt benutzt wird, und daß anschließend an die Ätzung vor der Durchführung des zweiten Arbeitsschrittes eine Temperung erfolgt.

2. Verfahren nach Anspruch 1, d a d u r c h   g e k e n n - z e i c h n e t,   daß das Aufbringen des Oberflächenüberzuges im ersten Arbeitsschritt stromlos durch chemische Abscheidung auf die Anschlußkontakte in einer Dicke von 10 bis 200 nm erfolgt.

3. Verfahren nach Anspruch 1 oder 2, d a d u r c h   g e k e n n z e i c h n e t,   daß die Temperung in Stickstoff-, Formiergas- oder Wasserstoffatmosphäre erfolgt, wobei der Oberflächenüberzug vollständig in die Anschlußkontakte hineindiffundiert.

4. Verfahren nach einem der Ansprüche 1, 2 oder 3, d a d u r c h   g e k e n n z e i c h n e t,   daß die Temperung 5 bis 30 Minuten lang bei 200 bis 450° C erfolgt.

5. Verfahren nach einem der vorhergehenden Ansprüche,
d a d u r c h   g e k e n n z e i c h n e t,   daß
das Aufbringen des Oberflächenüberzuges im zweiten
Arbeitsschritt stromlos durch chemische Abscheidung
auf die Anschlußkontakte in einer Dicke von 50 bis 200 nm
erfolgt.

Europäisches
Patentamt

**EUROPÄISCHER RECHERCHENBERICHT**

Nummer der Anmeldung

EP 84 11 4274

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | PATENTS ABSTRACTS OF JAPAN, Band 5 Nr.179, (E-82) (851) November 17, 1981, <br><br> & JP-A-56 105 653 (DAINI SEIKOSHA K.K.) (22-08-1981) <br><br> --- | 1 | H 01 L 21/60// <br> H 01 L 23/48 |
| Y | DE-A-2 613 759 (LICENTIA PATENT-VERWALTUNGS GmbH) <br><br> * Patentansprüche 2,5; Seite 12, Absatz 5 - Seite 13, Absatz 1 * <br><br> --- | 1,2 | |
| A | IBM TECHNICAL DISCLOSURE BULLETIN, Band 15, Nr.4, September, 1972, Seite 1088, NEW YORK, (US). J. ORDONEZ:"Protective coatings against corrosion in metal electrodes". <br><br> --- | 1,2,4 | |
| A | US-A-4 293 637 (MATSUSHITA ELECTRIC INDUSTRIAL CO.) <br><br> * Spalte 6, Zeilen 6-15, 46-47; Spalte 8, Zeilen 1-5 * <br><br> --- | 1,2 | |
| A | SOLID STATE TECHNOLOGY, Band 23, Nr.3, März, 1980, Seiten 69-76, WASHINGTON, (US). <br><br> -/- | 1,2 | |

RECHERCHIERTE
SACHGEBIETE (Int. Cl.4)

H 01 L

Der vorliegende Recherchenbericht wurde für alle Patentansprüche erstellt.

| Recherchenort | Abschlußdatum der Recherche | Prüfer |
|---|---|---|
| DEN HAAG | 27-02-1985 | DE RAEVE R. |

**Europäisches Patentamt**

**EUROPÄISCHER RECHERCHENBERICHT**

Nummer der Anmeldung

EP 84 11 4274

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| | T.LIU et al.:"A review of wafer bumping for tape automated bonding".<br><br>* Seite 73, Figur 6 *<br><br>--- | | |
| A | PATENTS ABSTRACTS OF JAPAN, Band 6, Nr.254, (E-148) (1132) Dezember, 14,1982.<br><br>& JP-A-57 154 829 (NIHON INTER-NATIONAL SEIRIYUUKI K.K.) (24-09-1982)<br><br>----- | 3 | |
| | | | **RECHERCHIERTE SACHGEBIETE (Int. Cl.4)** |

Der vorliegende Recherchenbericht wurde für alle Patentansprüche erstellt.

| Recherchenort | Abschlußdatum der Recherche | Prüfer |
|---|---|---|
| DEN HAAG | 27-02-1985 | DE RAEVE R. |